# EUROPÄISCHE PATENTSCHRIFT

(11) **EP 2 191 520 B1**
(45) Veröffentlichungstag und Bekanntmachung des Hinweises auf die Patenterteilung: **26.04.2017**
(21) Anmeldenummer: 08801300.8
(22) Anmeldetag: 04.09.2008
(51) Int. Cl.: H01L 33/40, H01L 33/38, H01L 33/14, H01L 33/00

(54) **LICHTEMITTIERENDE DÜNNFILM-DIODE MIT EINER SPIEGELSCHICHT UND VERFAHREN ZU DEREN HERSTELLUNG**
LIGHT EMITTING THIN-FILM DIODE HAVING A MIRROR LAYER AND METHOD FOR THE PRODUCTION THEREOF
DIODE ÉLECTROLUMINESCENTE À COUCHES MINCES DOTÉE D'UNE COUCHE MIROIR ET SON PROCÉDÉ DE FABRICATION

(30) Priorität: 28.09.2007 DE 102007046519
(43) Veröffentlichungstag der Anmeldung: 02.06.2010
(60) Teilanmeldung: 17159663.8
(73) Patentinhaber: Osram Opto Semiconductors Gmbh, 93055 Regensburg (DE)
(72) Erfinder: HAHN, Berthold, 93155 Hemau (DE); WEIMAR, Andreas, 93055 Regensburg (DE); BAUR, Johannes, 93051 Regensburg (DE); SABATHIL, Matthias, 93059 Regensburg (DE); PLAINE, Glenn-Ives, Tsuzuki-ku Yokohama-shi (JP)
(74) Vertreter: Epping - Hermann - Fischer
(86) Internationale Anmeldenummer: PCT/DE2008/001495
(87) Internationale Veröffentlichungsnummer: WO 2009/039820

(56) Entgegenhaltungen:
- EP-A- 1 383 177
- WO-A-2007/036164
- US-A- 5 404 031
- US-A1- 2003 111 667
- US-A1- 2006 011 935
- US-A1- 2006 060 879
- US-A1- 2007 114 545

## Beschreibung

Die Erfindung betrifft eine Dünnfilm-LED mit einer Spiegelschicht gemäß dem Patentanspruch 1 und ein Verfahren zu dessen Herstellung gemäß dem Patentanspruch 10.

Diese Patentanmeldung beansprucht die Priorität der deutschen Patentanmeldung 10 2007 046 519. 1.

Der Erfindung liegt die Aufgabe zugrunde, eine hinsichtlich der Strahlungsauskopplung effiziente Dünnfilm-LED, die sich insbesondere durch eine verminderte Absorption von Strahlung in den Kontaktschichten auszeichnet, und ein Verfahren zu dessen Herstellung anzugeben.

Diese Aufgabe wird durch eine Dünnfilm-LED mit den Merkmalen des Patentanspruchs 1 und durch ein Verfahren zu deren Herstellung mit den Merkmalen des Patentanspruchs 10 gelöst.

Vorteilhafte Ausgestaltungen und Weiterbildungen der Erfindung sind Gegenstand der abhängigen Patentansprüche.

Die Druckschrift US 2003/0111667 A1 beschreibt eine LED mit einem reflektivem Unterbau, wobei ein Reflektor zwischen einem elektrischen Leiter und einem emittierenden Bereich angeordnet ist.

Die Druckschrift WO 2007/036164 A1 beschreibt eine lichtemittierende Vorrichtung mit einer aktiven Schicht zwischen einer oberen und einer unteren Kontaktschicht, welche sich in ihrer Form voneinander unterscheiden.

Die Druckschrift US 2006/060879 A1 beschreibt eine LED mit zwei ohm schen Kontakten an gegenüberliegenden Seiten der LED.

Eine erfindungsgemäße Dünnfilm-LED umfasst eine Barriereschicht, eine der Barriereschicht nachfolgende erste Spiegelschicht, einen der ersten Spiegelschicht nachfolgenden Schichtstapel, der mindestens eine aktive Schicht aufweist, die elektromagnetische Strahlung emittiert und mindestens eine dem Schichtstapel nachfolgende Kontaktstruktur. Die Kontaktstruktur ist auf einer Strahlungsaustrittsfläche der Dünnfilm-LED angeordnet und weist eine Kontaktfläche auf. Die erste Spiegelschicht weist in einem der Kontaktfläche der Kontaktstruktur gegenüberliegenden Bereich eine Aussparung auf, die größer als die Kontaktfläche der Kontaktstruktur ist.

Die erste Spiegelschicht ist also derart strukturiert, dass der Kontaktfläche der Kontaktstruktur in vertikaler Richtung ein nicht von der ersten Spiegelschicht bedeckter Bereich der Barriereschicht gegenüber liegt, der größer als die Kontaktfläche der Kontaktstruktur ist.

Bei einer Ausgestaltung der Dünnfilm-LED kann die Barriereschicht im Bereich der Aussparung der ersten Spiegelschicht direkt an eine der Kontaktstruktur gegenüberliegende Grenzfläche des Schichtstapels angrenzen.

Die Kontaktstruktur kann ein Bondpad und/oder mehrere mit dem Bondpad elektrisch verbundene Kontaktstege umfassen, um eine bessere Stromaufweitung zu erzielen. Durch eine Anordnung mit mehreren mit dem Bondpad elektrisch leitend verbundenen Kontaktstegen kann eine vergleichsweise homogene Stromverteilung in der Dünnfilm-LED erreicht werden.

Unter der Kontaktfläche der Kontaktstruktur wird im Folgenden bei Verwendung eines Bondpads eine Hauptfläche des Bondpads verstanden. Bei Verwendung eines Bondpads mit mehreren mit dem Bondpad elektrisch verbundenen Kontaktstegen wird im Folgenden unter der Kontaktfläche die gesamte von dem Bondpad und den Kontaktstegen gebildete Hauptfläche verstanden.

Die erste Spiegelschicht ist als reflektierende Kontaktschicht ausgebildet, wobei die erste Spiegelschicht in einem der Kontaktfäche der Kontaktstruktur gegenüberliegenden Bereich eine Aussparung aufweist. Die von der aktiven Schicht aus gesehen der Strahlungsaustrittsfläche gegenüberliegende erste Spiegelschicht ist also derart strukturiert, dass der Kontaktstruktur in vertikaler Richtung von der aktiven Schicht aus gesehen ein nicht von der ersten Spiegelschicht bedeckter Bereich der Hauptfläche des Schichtstapels gegenüber liegt.

Da der ausgesparte Bereich keine als reflektierende Kontaktschicht wirkende erste Spiegelschicht aufweist, entsteht in der Aussparung kein elektrischer Kontakt an dem angrenzenden Schichtstapel. Dadurch wird der Stromfluss zwischen der Kontaktstruktur auf der Strahlungsaustrittsfläche und der Aussparung in dem Bereich des Schichtstapels, der in vertikaler Richtung unterhalb und unmittelbar neben der Kontaktfläche der Kontaktstruktur liegt, vermindert. Die Strahlungserzeugung in diesem Bereich der aktiven Schicht ist somit vermindert, wodurch vorteilhaft die Absorption von Strahlung innerhalb der Kontaktstruktur reduziert wird. Weiterhin wird durch die Aussparung der ersten Spiegelschicht der Anteil der emittierten Strahlung, der von der ersten Spiegelschicht in Richtung der Kontaktstruktur reflektiert wird, vermindert. Auf diese Weise wird die Absorption von Strahlung in der Kontaktstruktur weiter vermindert. Die Effizienz der Dünnfilm-LED wird dadurch vorteilhaft erhöht.

Durch die Barriereschicht wird eine Diffusion von Material in die erste Spiegelschicht verhindert.

Die LED ist erfindungsgemäß als Dünnfilm-LED ausgeführt. Bei einer Dünnfilm-LED ist das Herstellungssubstrat, auf dem der Schichtstapel für die LED hergestellt, insbesondere abgeschieden wurde, bereichsweise oder vollständig entfernt. Das Herstellungssubstrat ist vorzugsweise das Aufwachssubstrat, auf dem der Schichtstapel epitaktisch gewachsen ist. Das Herstellungssubstrat ist vorzugsweise derart entfernt, dass die dem Herstellungssubstrat zugewandte Oberfläche des Schichtstapels einer weiteren Prozessierung zugänglich ist.

Vorzugsweise ist die laterale Ausdehnung der Aussparung der ersten Spiegelschicht um 5 µm bis 20 µm größer als die laterale Ausdehnung der Kontaktfläche der Kontaktstruktur.

Durch die Aussparung kann eine Verminderung der Stromdichte in dem Bereich der aktiven Schicht, der in vertikaler Richtung unterhalb der Kontaktfläche der Kontaktstruktur und in dem Bereich, der in vertikaler Richtung unmittelbar neben der Kontaktfläche der Kontaktstruktur liegt, erreicht werden. Das bedeutet, dass eine räumliche Trennung zwischen Bereichen der aktiven Schicht, in denen Lichterzeugung stattfindet, und Bereichen der aktiven Schicht, in denen nur eine geringe oder vorzugsweise keine Lichterzeugung stattfindet, erreicht wird. Die Bereiche der geringen Lichterzeugung liegen direkt unterhalb und unmittelbar neben der Kontaktfläche der Kontaktstruktur, die für die von der aktiven Schicht emittierte Strahlung absorbierend wirkt. Durch die räumliche Trennung wird der Anteil der von der aktiven Schicht emittierten Strahlung, der von der Kontaktstruktur absorbiert wird, reduziert. Die Effizienz der Dünnfilm-LED erhöht sich dadurch mit Vorteil.

Eine gegenüber der lateralen Ausdehnung der Kontaktfläche um über 20 µm vergrößerte laterale Ausdehnung der Aussparung ist alternativ auch möglich. Dadurch wird die Lichtauskopplung der Dünnfilm-LED zwar nicht nachteilig beeinflusst, allerdings ergibt sich mit einer über 20 µm vergrößerten lateralen Ausdehnung der Aussparung eine erhöhte Diodenspannung, die eine reduzierte Effizienz der aktiven Schicht zur Folge hat.

Gemäß der Erfindung ist eine Grenzfläche des Schichtstapels, die der Strahlungsaustrittsfläche gegenüber liegt, im Bereich der Aussparung derart verändert, dass sich der Kontaktwiderstand zwischen dem Schichtstapel und dem ausgesparten Bereich der ersten Spiegelschicht erhöht, wobei die Grenzfläche im Bereich der Aussparung nicht elektrisch leitend ist.

Da in dem ausgesparten Bereich der ersten Spiegelschicht der Kontaktwiderstand zwischen dem Schichtstapel und dem ausgesparten Bereich der ersten Spiegelschicht erhöht und/oder die Grenzfläche des Schichtstapels im Bereich der Aussparung nicht elektrisch leitend ist, ist der Stromfluss und somit die Lichterzeugung in der aktiven Schicht in Bereichen unterhalb und direkt neben der Kontaktstruktur vermindert, wodurch sich eine Absorption der von der aktiven Schicht emittierten Strahlung in der Kontaktstruktur reduziert.

Die Aussparung der ersten Spiegelschicht weist eine zweite Spiegelschicht auf.

Durch die veränderte Grenzfläche des Schichtstapels vermindert sich die Stromdichte in dem Bereich der aktiven Schicht, der in vertikaler Richtung unterhalb und unmittelbar neben der Kontaktfläche der Kontaktstruktur liegt, so dass weniger Strahlung unterhalb der Kontaktfläche der Kontaktstruktur erzeugt wird. Durch die zweite Spiegelschicht, die sich in der Aussparung der ersten Spiegelschicht und somit auf der Grenzfläche des Schichtstapels befindet, wird der Anteil der emittierten Strahlung, der in Richtung der Aussparung der ersten Spiegelschicht reflektiert wird, an der zweiten Spiegelschicht in Richtung der Strahlungsaustrittsfläche reflektiert. Dadurch kann dieser Anteil der emittierten Strahlung an der Strahlungsaustrittsfläche der Dünnfilm-LED ausgekoppelt werden. Mit Vorteil erhöht sich auf diese Weise die Effizienz der Dünnfilm-LED.

Eine weitere bevorzugte Ausgestaltung der Erfindung sieht vor, dass eine dem Schichtstapel zugewandte Hauptfläche der Kontaktstruktur eine reflektierende Schicht aufweist. Besonders bevorzugt enthält die reflektierende Schicht Ag, Al und/oder Pt.

Durch die reflektierende Schicht auf der dem Schichtstapel zugewandten Hauptfläche der Kontaktstruktur wird der Anteil der emittierten Strahlung, der von der zweiten Spiegelschicht in Richtung der Hauptfläche der Kontaktstruktur reflektiert wird, zurück in Richtung der ersten oder der zweiten Spiegelschicht reflektiert. Dieser Anteil der emittierten Strahlung wird wiederum an der ersten oder der zweiten Spiegelschicht in Richtung der Strahlungsaustrittsfläche der Dünnfilm-LED reflektiert. Auf diese Weise vermindert sich die Absorption von Strahlung in der Kontaktstruktur, besonders bevorzugt wird keine emittierte Strahlung von der Kontaktstruktur absorbiert. Dadurch erhöht sich die Effizienz der Dünnfilm-LED vorteilhaft.

Bevorzugt ist die Strahlungsaustrittsfläche des Schichtstapels aufgeraut. Durch die Aufrauung der Strahlungsaustrittsfläche erniedrigt sich die Reflektivität an der Grenzfläche zwischen Schichtstapel und einem den Schichtstapel umgebenes Medium. Dadurch wird ein höherer Anteil der Strahlung, der auf die Grenzfläche trifft, aus dem Schichtstapel ausgekoppelt. Somit verringert sich der Anteil der von der aktiven Schicht emittierten Strahlung, der an der Strahlungsaustrittsfläche in Richtung der aktiven Schicht zurück reflektiert wird. Die Effizienz der Dünnfilm-LED erhöht sich mit Vorteil.

Eine weitere Ausgestaltung der Erfindung sieht vor, dass die Bereiche des Schichtstapels, auf denen die Kontaktstruktur angeordnet ist, eine geringere Schichthöhe aufweisen als Bereiche des Schichtstapels, auf denen keine Kontaktstruktur angeordnet ist. Dadurch kann eine weitere Intensitätssteigerung der von dem Schichtstapel emittierten Strahlung erreicht werden.

Bevorzugt weist der Schichtstapel, auf dem keine Kontaktstruktur aufgebracht ist, eine Schichthöhe zwischen 4 µm und 8 µm, besonders bevorzugt von 6 µm auf. Die Bereiche des Schichtstapels, auf die die Kontaktstruktur aufgebracht ist, weisen bevorzugt eine Schichthöhe zwischen 50 nm und 3,5 µm, besonders bevorzugt im Bereich zwischen 100 nm und 2 µm auf.

Vorzugsweise weist mindestens eine der Seitenflächen des Schichtstapels eine weitere reflektierende Schicht auf. Dadurch wird der Anteil der emittierten Strahlung, der ohne die mindestens eine weitere reflektierende Schicht aus dem Schichtstapel lateral ausgekoppelt werden würde, in Richtung des Schichtstapels reflektiert. Durch weitere Reflektionen im Schichtstapel kann dieser Anteil der emittierten Strahlung in Richtung der Strahlungsaustrittsfläche reflektiert und ausgekoppelt werden. Dadurch erhöht sich die Effizienz der Dünnfilm-LED weiter vorteilhaft.

Bevorzugt enthält die weitere reflektierende Schicht, die an mindestens einer der Seitenfläche des Schichtstapels aufgebracht ist, Ag, Al und/oder Pt.

Bei einer weiteren vorteilhaften Ausgestaltung der Erfindung ist auf mindestens einem Teilbereich der Strahlungsaustrittsfläche der Dünnfilm-LED eine Lumineszenzkonversionsschicht aufgebracht. Die Lumineszenzkonversionsschicht enthält zumindest einen Lumineszenzkonversionsstoff, der zur Wellenlängenkonversion zumindest eines Teils der von der Dünnfilm-LED emittierten Strahlung zu größeren Wellenlängen hin geeignet ist. Auf diese Weise kann insbesondere mit einer Dünnfilm-LED, die ultraviolette oder blaue Strahlung emittiert, durch Wellenlängenkonversion eines Teils der emittierten Strahlung in den komplementären Spektralbereich, beispielsweise den gelben Spektralbereich, Weißlicht erzeugt werden. Geeignete Lumineszenzkonversionsstoffe, wie zum Beispiel YAG:Ce, sind aus der WO 98/12757 bekannt, deren Inhalt hiermit insbesondere in Bezug auf Leuchtstoffe durch Referenz aufgenommen wird.

Ein weiterer Vorteil einer auf der Strahlungsaustrittsfläche aufgebrachten Lumineszenzkonversionsschicht ergibt sich dadurch, dass sich die Effizienz der Dünnfilm-LED vorteilhaft verbessert, da sich durch die Lumineszenzkonversionsschicht die Anzahl der Rückreflektionen der von der aktiven Schicht emittierten Strahlung in Richtung des Schichtstapels weiter reduziert. Das beruht darauf, dass bevorzugt der Brechungsindexunterschied zwischen Schichtstapel und Lumineszenzkonversionsschicht kleiner ist als der Brechungsindexunterschied zwischen Schichtstapel und das dem Schichtstapel umgebene Medium. Durch einen niedrigeren Brechungsindexunterschied an der Strahlungsaustrittsfläche erhöht sich der Anteil der Strahlung, der aus dem Schichtstapel ausgekoppelt wird.

Bevorzugt basiert der Schichtstapel der Dünnfilm-LED auf einem Nitrid-Verbindungshalbleiter. "Auf Nitrid-Verbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalische Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Die erste und/oder zweite Spiegelschicht enthält vorzugsweise Al und/oder Pt, besonders bevorzugt Ag. Die Barriereschicht enthält bevorzugt TiWN.

Die aktive Schicht der Dünnfilm-LED umfasst bevorzugt einen pn-Übergang, eine Doppelheterostruktur, einen Einfach-Quantentopf oder besonders bevorzugt eine Mehrfach-Quantentopfstruktur (MQW) zur Strahlungserzeugung. Die Bezeichnung Quantentopfstruktur beinhaltet hierbei keine Angabe über die Dimensionalität der Quantisierung. Sie umfasst somit u.a. Quantentröge, Quantendrähte und Quantenpunkte und jede Kombination dieser Strukturen.

Ein Verfahren zur Herstellung einer erfindungsgemäßen Dünnfilm-Diode umfasst folgende Verfahrensschritte:
- Bereitstellen eines Aufwachssubstrats,
- epitaktisches Aufwachsen eines Schichtstapels, der geeignet ist, elektromagnetische Strahlung zu erzeugen,
- Aufbringen einer ersten Spiegelschicht, die eine Aussparung in einem Bereich, der einem vorgesehenen Bereich einer Kontaktstruktur gegenüber liegt, aufweist,
- Aufbringen einer Barriereschicht auf der ersten Spiegelschicht,
- Ablösen des Schichtstapels von dem Aufwachssubstrat,
- Aufbringen einer Kontaktstruktur, die eine Kontaktfläche aufweist, auf der der ersten Spiegelschicht
   gegenüberliegenden Seite des Schichtstapels, wobei die Kontaktstruktur in einem der Aussparung der ersten Spiegelschicht gegenüberliegenden Bereich aufgebracht wird, und die Kontaktfläche der Kontaktstruktur kleiner als die Aussparung der ersten Spiegelschicht ist.

Die erste Spiegelschicht wird also derart strukturiert, dass der Kontaktfläche der Kontaktstruktur in vertikaler Richtung ein nicht von der ersten Spiegelschicht bedeckter Bereich der Barriereschicht gegenüber liegt, der größer ist als die Kontaktfläche der Kontaktstruktur. Die erste Spiegelschicht ist als reflektierende Kontaktschicht ausgebildet, die vorzugsweise einen ohmschen Kontakt zum angrenzenden Schichtstapel herstellt.

Durch die Aussparung ist die Stromdichte in einem Bereich der aktiven Schicht, der in vertikaler Richtung unterhalb und unmittelbar neben der Kontaktfläche der Kontaktstruktur liegt, vermindert, so dass weniger Strahlung von der aktiven Schicht unterhalb der Kontaktfläche der Kontaktstruktur erzeugt wird. Weiterhin wird durch die Aussparung der ersten Spiegelschicht der Anteil der emittierten Strahlung, der von der ersten Spiegelschicht in Richtung der Kontaktfläche der Kontaktstruktur reflektiert wird, vermindert. Auf diese Weise wird die Absorption von Strahlung in der Kontaktstruktur vermindert. Die Effizienz der Dünnfilm-LED wird dadurch vorteilhaft erhöht.

Eine vorteilhafte Weiterbildung des Verfahrens sieht vor, dass vor Aufbringen der Barriereschicht die Grenzfläche des Schichtstapels in dem Bereich der Aussparung der ersten Spiegelschicht durch einen Plasmaprozess beschädigt wird. Insbesondere kann die Grenzfläche des Schichtstapels in dem Bereich der Aussparung der ersten Spiegelschicht durch einen Sputterprozess beschädigt werden. Bevorzugt wird die Grenzfläche des Schichtstapels in dem Bereich der Aussparung der ersten Spiegelschicht derart beschädigt, dass die Grenzfläche des Schichtstapels in diesem Bereich nicht elektrisch leitend ist.

Da die Grenzfläche des Schichtstapels in der Aussparung nicht elektrisch leitend ist, ist die Stromdichte der aktiven Schicht im Bereich der Aussparung vermindert, so dass weniger Strahlung von der aktiven Schicht unterhalb der Kontaktfläche der Kontaktstruktur erzeugt wird. Dadurch reduziert sich mit Vorteil der Anteil der von der aktiven Schicht emittierten Strahlung, der von der Kontaktstruktur absorbiert wird.

Eine weitere vorteilhafte Weiterbildung des Verfahrens sieht vor, dass vor Aufbringen der Barriereschicht eine zweite Spiegelschicht auf die beschädigte Grenzfläche des Schichtstapels in der Aussparung der ersten Spiegelschicht aufgebracht wird. Durch die zweite Spiegelschicht wird der Anteil der emittierten Strahlung, der in Richtung der Aussparung der ersten Spiegelschicht reflektiert wird, an der zweiten Spiegelschicht in Richtung Strahlungsaustrittsfläche reflektiert. Dadurch kann dieser Anteil der emittierten Strahlung an der Strahlungsaustrittsfläche der Dünnfilm-LED ausgekoppelt werden. Die Effizienz der Dünnfilm-LED erhöht sich vorteilhaft.

Bei zumindest einer weiteren Ausgestaltung wird die Strahlungsaustrittsfläche des Schichtstapels vor Aufbringen der Kontaktstruktur aufgeraut. Durch die Aufrauung der Strahlungsaustrittsfläche erniedrigt sich die Reflektivität an der Strahlungsaustrittsfläche, wodurch sich die Anzahl an Rückreflektionen an der Strahlungsaustrittsfläche in Richtung der aktiven Schicht verringert. Dadurch kann ein größerer Anteil der Strahlung, die auf die Strahlungsaustrittsfläche trifft, aus der Dünnfilm-LED ausgekoppelt werden. Die Effizienz der Dünnfilm-LED erhöht sich mit Vorteil.

Bevorzugt sieht eine weitere Ausgestaltung des Verfahrens vor, dass vor Aufbringen der Kontaktstruktur auf den Schichtstapel eine reflektierende Schicht auf die Teilbereiche des Schichtstapels aufgebracht wird, die für die Kontaktstruktur vorgesehen sind. Dadurch wird der Anteil der Strahlung, der von der aktiven Schicht der Dünnfilm-LED ausgesandt wird und ohne die zusätzliche reflektierende Schicht von der Kontaktstruktur absorbiert werden würde, in Richtung der ersten oder der zweiten Spiegelschicht und von dieser wieder in Richtung der Strahlungsaustrittsfläche reflektiert, so dass die Strahlung aus der Dünnfilm-LED ausgekoppelt werden kann. Dadurch erhöht sich die Effizienz der Dünnfilm-LED weiter vorteilhaft.

Eine weitere vorteilhafte Weiterbildung des Verfahrens sieht vor, dass Bereiche des Schichtstapels, auf die die Kontaktstruktur aufgebracht ist, vor Aufbringen der Kontaktstruktur trockenchemisch behandelt werden. Dadurch ergeben sich Bereiche des Schichtstapels, auf denen die Kontaktstruktur angeordnet ist, die eine geringere Schichthöhe aufweisen als Bereiche des Schichtstapels, auf denen keine Kontaktstruktur angeordnet ist. Dadurch kann eine weitere Intensitätssteigerung der von der Dünnfilm-LED emittierten Strahlung erreicht werden.

Bevorzugt sieht eine Weiterbildung des Verfahrens vor, dass zusätzlich auf mindestens eine der Seitenflächen des Schichtstapels eine weitere reflektierende Schicht aufgebracht wird. Dadurch wird der Anteil der Strahlung, der von der aktiven Schicht der Dünnfilm-LED lateral ausgesandt wird, in Richtung des Schichtstapels zurück reflektiert. Durch weitere Reflektionen im Schichtstapel kann dieser Anteil der emittierten Strahlung in Richtung der Strahlungsaustrittsfläche reflektiert und ausgekoppelt werden. Dadurch erhöht sich die Effizienz der Dünnfilm-LED weiter vorteilhaft.

Weitere Merkmale, Vorteile, bevorzugte Ausgestaltungen und Zweckmäßigkeiten der Dünnfilm-LED ergeben sich aus den im Folgenden in Verbindung mit den Figuren 1 bis 4 erläuterten Ausführungsbeispielen. Es zeigen:
Figur 1 einen schematischen Querschnitt eines Vergleichsbeispiels einer Dünnfilm-LED,
Figur 2 einen schematischen Querschnitt eines ersten Ausführungsbeispiels einer erfindungsgemäßen Dünnfilm-LED,
Figur 3 einen schematischen Querschnitt eines zweiten Ausführungsbeispiels einer erfindungsgemäßen Dünnfilm-LED, und
Figur 4 einen schematischen Querschnitt eines dritten Ausführungsbeispiels einer erfindungsgemäßen Dünnfilm-LED.

Gleiche oder gleichwirkende Bestandteile sind jeweils mit den gleichen Bezugszeichen versehen. Die dargestellten
Bestandteile sowie die Größenverhältnisse der Bestandteile untereinander sind nicht als maßstabsgerecht anzusehen.

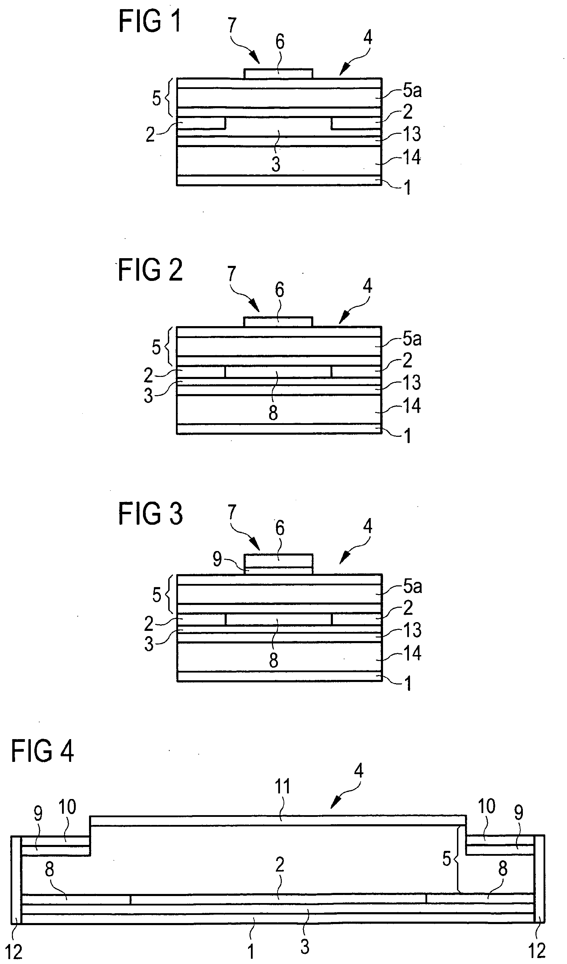

Die in Figur 1 dargestellte Dünnfilm-LED stellt ein Vergleichsbeispiel einer Dünnfilm-LED dar. Die Dünnfilm-LED umfasst eine Barriereschicht 3, eine nachfolgende erste Spiegelschicht 2 und einen darauf angeordneten Schichtstapel 5. Der Schichtstapel 5 weist eine aktive Schicht 5a auf, die bei Betrieb elektromagnetische Strahlung emittiert. Eine Kontaktstruktur 6, die als Bondpad ausgebildet ist, ist auf einer Strahlungsaustrittsfläche 4 angeordnet und weist eine Kontaktfläche 7 auf. Die erste Spiegelschicht 2 weist in einem der Kontaktfläche 7 des Bondpads 6 gegenüberliegenden Bereich eine Aussparung auf, wobei die Aussparung der ersten Spiegelschicht 2 größer als die Kontaktfläche 7 des Bondpads 6 ist.

Die erste Spiegelschicht 2 ist also derart strukturiert, dass in vertikaler Richtung der Kontaktfläche 7 des Bondpads 6 ein nicht von der ersten Spiegelschicht 2 bedeckter Bereich der Barriereschicht 3 gegenüber liegt.

Die erste Spiegelschicht 2 ist als reflektierende Kontaktschicht ausgebildet, die einen dem Bondpad 6 von der aktiven Schicht 5a aus gesehen gegenüberliegenden zweiten elektrischen Kontakt der Dünnfilm-LED ausbildet.

Die Dünnfilm-LED basiert bevorzugt auf einem Nitridverbindungshalbleiter. Die erste Spiegelschicht 2 enthält vorzugsweise Ag. Die erste Spiegelschicht 2 ist durch eine Barriereschicht 3, die bevorzugt TiWN enthält, gekapselt, um Ag-Migration zu verhindern.

Die Aussparung der ersten Spiegelschicht 2, und somit der reflektierenden Kontaktschicht, hat den Vorteil, dass die Stromdichte in einem Bereich der aktiven Schicht 5a, der in vertikaler Richtung unterhalb und unmittelbar neben der Kontaktfläche 7 des Bondpads 6 liegt, vermindert ist, so dass weniger Strahlung unterhalb und unmittelbar neben der Kontaktfläche 7 des Bondpads 6 erzeugt wird, wodurch sich der Anteil der von der aktiven Schicht 5a emittierten Strahlung, der von dem Bondpad 6 absorbiert wird, reduziert. Ferner wird durch die Aussparung der ersten Spiegelschicht 2 der Anteil der emittierten Strahlung, der von der ersten Spiegelschicht 2 in Richtung des Bondpads 6 reflektiert wird, weiter vermindert. Auf diese Weise wird die Absorption von Strahlung in dem Bondpad 6 vermindert. Die Effizienz der Dünnfilm-LED wird dadurch vorteilhaft erhöht.

Vorzugsweise ist die laterale Ausdehnung der Aussparung um 5 µm bis 20 µm größer als die laterale Ausdehnung der Kontaktfläche 7 des Bondpads 6. Dadurch wird die Stromdichte in einem Bereich, der unterhalb und unmittelbar neben dem Bondpad liegt, das als Absorber wirkt, unterdrückt, wodurch sich der Anteil der durch die Strahlungsaustrittsfläche 4 ausgekoppelten Strahlung erhöht. Eine gegenüber der lateralen Ausdehnung der Kontaktfläche 7 um über 20 µm vergrößerte laterale Ausdehnung der Aussparung ist alternativ auch möglich. Allerdings ergibt sich dabei eine erhöhte Diodenspannung und somit eine reduzierte Effizienz der aktiven Schicht 5a.

An einer der Strahlungsaustrittsfläche 4 gegenüberliegenden Seite des Schichtstapels 5 kann die Dünnfilm-LED auf einem Träger 14 befestigt sein. Beispielsweise ist der Schichtenstapel 5 mittels einer Verbindungsschicht 13, die insbesondere eine Lotschicht sein kann, auf dem Träger 14 befestigt. Der Träger 14 ist beispielsweise eine Leiterplatte, insbesondere eine gedruckte Leiterplatte (Printed Circuit Board). Ferner kann der Träger 14 aus einer Keramik, die insbesondere Aluminiumnitrid enthalten kann, gebildet sein. Auch Träger 14 aus einem Halbleitermaterial, wie beispielsweise Ge- oder GaAs-Träger, können verwendet werden. Eine von dem Schichtstapel 5 abgewandte Rückseite des Trägers 14 kann beispielsweise mit einer elektrischen Kontaktschicht 1 versehen sein, die einen dem Bondpad 6 von der aktiven Schicht 5a aus gesehen gegenüberliegenden zweiten elektrischen Kontakt der Dünnfilm-LED ausbildet.

Durch die Barriereschicht 3 wird insbesondere eine Diffusion von Material der Verbindungsschicht 13, die beispielsweise eine Lotschicht ist, in die erste Spiegelschicht 2 verhindert, durch die insbesondere die Reflektion der ersten Spiegelschicht 2 beeinträchtigt werden könnte.

Die in Figur 2 dargestellte erfindungsgemäße Dünnfilm-LED weist im Gegensatz zu der Dünnfilm-LED aus Figur 1 in der Aussparung der ersten Spiegelschicht 2 eine zweite Spiegelschicht 8 auf, so dass die Barriereschicht 3, die bevorzugt TiWN enthält und für die von der aktiven Schicht 5a emittierte Strahlung absorbierend wirkt, nicht direkt an den Schichtstapel 5 im Bereich der Aussparung der ersten Spiegelschicht 2 angrenzt.

Die zweite Spiegelschicht 8 weist zu dem Schichtstapel 5 einen hohen Kontaktwiderstand auf, während die erste Spiegelschicht 2 einen niedrigen Kontaktwiderstand zu dem Schichtstapel 5 aufweist. Der erhöhte Kontaktwiderstand und die geringe Leitfähigkeit zwischen dem Schichtstapel 5 und der zweiten Spiegelschicht 8 kommt durch eine veränderte Grenzfläche des Schichtstapels 5 im Bereich der Aussparung zustande, so dass die Grenzfläche des Schichtstapels 5 im Bereich der Aussparung nicht elektrisch leitend ist.

Ferner besteht die Möglichkeit, dass durch ein geeignetes Material die zweite Spiegelschicht 8 im Vergleich zur ersten Spiegelschicht 2 eine geringere Leitfähigkeit aufweist.

Da in dem ausgesparten Bereich durch die Änderung der Grenzfläche des Schichtstapels kein elektrischer Kontakt zwischen der zweiten Spiegelschicht 2 und dem angrenzenden Schichtstapel 5 entsteht, wird der Stromfluss zwischen dem Bondpad 6 auf der Strahlungsaustrittsfläche 4 und der zweiten Spiegelschicht 8 in dem Bereich des Schichtstapels 5 der in vertikaler Richtung unterhalb und unmittelbar neben der Kontaktfläche 7 des Bondpads 6 liegt, vermindert. Die Strahlungserzeugung in diesem Bereich der aktiven Schicht 5a ist somit vermindert, wodurch vorteilhaft die Absorption von Strahlung innerhalb des Bondpads 6 reduziert wird.

Die zweite Spiegelschicht 8 enthält vorzugsweise Ag. Alternativ kann die zweite Spiegelschicht 8 Pt enthalten.

Die in Figur 3 dargestellte erfindungsgemäße Dünnfilm-LED unterscheidet sich von der in Figur 2 dargestellten Dünnfilm-LED dadurch, dass die dem Schichtstapel 5 zugewandte Hauptfläche des Bondpads 6 eine reflektierende Schicht 9 aufweist. Die reflektierende Schicht 9 enthält vorzugsweise Ag. Alternativ kann die reflektierende Schicht Al und/oder Pt enthalten.

Die in Figur 3 ausgeführte Dünnfilm-LED weist eine erste Spiegelschicht 2 auf, die als reflektierende Kontaktschicht ausgebildet ist, und die einen dem Bondpad 6 von der aktiven Schicht 5a aus gesehen gegenüberliegenden zweiten elektrischen Kontakt der Dünnfilm-LED ausbildet.

Durch die reflektierende Schicht 9 auf der dem Schichtstapel zugewandten Hauptfläche des Bondpads 6 wird der Anteil der emittierten Strahlung, der von der ersten oder der zweiten Spiegelschicht 2, 8 in Richtung des Bondpads 6 reflektiert wird, von der reflektierenden Schicht 9 zurück in Richtung der ersten und zweiten Spiegelschicht 2, 8 reflektiert. Dieser Anteil der emittierten Strahlung wird wiederum an der ersten oder der zweiten Spiegelschicht 2, 8 in Richtung der Strahlungsaustrittsfläche 4 der Dünnfilm-LED reflektiert und kann durch die Strahlungsaustrittsfläche 4 aus der Dünnfilm-LED ausgekoppelt werden. Auf diese Weise vermindert sich weiter die Absorption von Strahlung in dem Bondpad 6. Bevorzugt wird keine emittierte Strahlung von dem Bondpad 6 absorbiert. Die Effizienz der Dünnfilm-LED erhöht sich vorteilhaft.

Bevorzugt ist die Strahlungsaustrittsfläche 4 der Dünnfilm-LED aufgeraut. Durch diese Aufrauung erniedrigt sich die Reflektivität der Strahlungsaustrittsfläche 4. Dadurch wird ein geringerer Anteil der von der aktiven Schicht emittierten Strahlung an der Strahlungsaustrittsfläche 4 in Richtung der aktiven Schicht 5a zurück reflektiert, wodurch ein größerer Anteil der von der aktiven Schicht emittierten Strahlung an der Strahlungsaustrittsfläche 4 ausgekoppelt wird und sich dadurch die Effizienz der Dünnfilm-LED erhöht.

Die in Figur 4 dargestellte Dünnfilm-LED unterscheidet sich von der Dünnfilm-LED in Figur 3 dadurch, dass die Kontaktstruktur aus einem Bondpad (nicht dargestellt) und Kontaktstegen 10 gebildet ist. Unterhalb der Kontaktstege 10 und dem Bondpad ist die erste Spiegelschicht 2 ausgespart, wobei die laterale Ausdehnung der Aussparungen im Vergleich zur lateralen Ausdehnung der Kontaktfläche der Kontaktstruktur größer ist. Die Grenzfläche des Schichtstapels 5 ist in dem Bereich der Aussparungen der ersten Spiegelschicht 2 derart verändert, dass die Grenzfläche des Schichtstapels im Bereich der Aussparungen nicht elektrisch leitend ist. In den Aussparungen ist jeweils eine zweite Spiegelschicht 8 angeordnet.

Ferner ist im Unterschied zu dem Ausführungsbeispiel aus Figur 3 auf der der ersten und zweiten Spiegelschicht gegenüberliegenden Seite der Barriereschicht eine Kontaktschicht 1 angeordnet, die einen der Kontaktstruktur von der aktiven Schicht 5a aus gesehen gegenüberliegenden zweiten elektrischen Kontakt der Dünnfilm-LED ausbildet.

Durch die Veränderung der Grenzfläche des Schichtstapels 5 in Bereichen der zweiten Spiegelschicht 8 ist die Grenzfläche des Schichtstapels 5 nicht elektrisch leitend, wodurch sich die Lichterzeugung in der aktiven Schicht 5a in Bereichen unterhalb und unmittelbar neben der Kontaktstruktur vermindert. Dadurch ergibt sich eine reduzierte Absorption der von der aktiven Schicht 5a emittierten Strahlung in der Kontaktstruktur.

Die Seitenflächen des Schichtstapels 5 weisen eine weitere reflektierende Schicht 12 auf, die vorzugsweise Ag, Al und/oder Pt enthält. Weiterhin kann auf der Strahlungsaustrittsfläche 4, die keinen Bondpad oder Kontaktstege 10 aufweist, eine Lumineszenzkonversionsschicht 11 aufgebracht sein. Die Lumineszenzkonversionsschicht 11 enthält zumindest einen Lumineszenzkonversionsstoff, der zur Wellenlängenkonversion zumindest eines Teils der von der Dünnfilm-LED emittierten Strahlung zu größeren Wellenlängen hin geeignet ist. Auf diese Weise kann insbesondere mit einer Dünnfilm-LED, die ultraviolette oder blaue Strahlung emittiert, durch Wellenlängenkonversion eines Teils der emittierten Strahlung in den komplementären Spektralbereich, vorzugsweise den gelben Spektralbereich, Weißlicht erzeugt werden.

Die Bereiche des Schichtstapels 5, auf die Kontaktstege 10 aufgebracht sind, weisen bevorzugt eine geringere Schichthöhe auf als Bereiche des Schichtstapels 5, auf die keine Kontaktstege 10 aufgebracht sind. Dadurch kann eine weitere Intensitätssteigerung der von der Dünnfilm-LED emittierten Strahlung erreicht werden. Bevorzugt weist der Schichtstapel 5, auf dem keine Kontaktstege 10 aufgebracht sind, eine Schichthöhe zwischen 4 µm und 8 µm, beispielsweise eine Schichthöhe von 6 µm auf. Die Bereiche des Schichtstapels 5, auf die Kontaktstege 10 aufgebracht sind, weisen bevorzugt eine Schichthöhe zwischen 50 nm und 3,5 µm, beispielsweise eine Schichthöhe von 1 µm auf.

Die Reduzierung der Schichthöhe der Bereiche des Schichtstapels 5, auf die Kontaktstege 10 aufgebracht sind, erfolgt vorzugsweise trockenchemisch. Die Veränderung der Grenzfläche des Schichtstapels 5 erfolgt bevorzugt durch einen Plasmaprozess, besonders bevorzugt durch einen Sputterprozess.

Die Beschreibung der Ausführungsbeispiele ist nicht als Einschränkung auf die Anzahl der einzelnen Schichten zu verstehen. Einzelne Schichten der Dünnfilm-LED können sich ebenso aus einer Schichtenfolge zusammensetzen. Ebenso kann die Dünnfilm-LED zusätzlich zu den oben genannten Schichten beispielsweise Bufferschichten und/oder Zwischenschichten enthalten.

Die Erläuterung des erfindungsgemäßen Dünnfilm-LED anhand der oben beschriebenen Ausführungsbeispiele ist nicht als Beschränkung der Erfindung auf diese zu betrachten. Vielmehr umfasst die Erfindung jedes neue Merkmal sowie jede Kombination von Merkmalen, was insbesondere jede Kombination von Merkmalen in den Patentansprüchen beinhaltet.

## Patentansprüche

1. Lichtemittierende Dünnfilm-Diode, umfassend
- eine Barriereschicht (3),
- eine der Barriereschicht (3) nachfolgende erste Spiegelschicht (2), die als reflektierende Kontaktschicht ausgeführt ist,
- einen der ersten Spiegelschicht (2) nachfolgenden Schichtstapel (5), der mindestens eine aktive Schicht (5a) aufweist, die elektromagnetische Strahlung emittiert, und
- mindestens eine dem Schichtstapel (5) nachfolgende Kontaktstruktur (6), die auf einer Strahlungsaustrittsfläche (4) angeordnet ist und die eine Kontaktfläche (7) aufweist, wobei die Barriereschicht (3) dazu ausgebildet ist, eine Diffusion von Material in die erste Spiegelschicht (2) zu verhindern,
**dadurch gekennzeichnet, dass**
die erste Spiegelschicht (2) in einem der Kontaktfläche (7) der Kontaktstruktur (6) gegenüberliegenden Bereich eine Aussparung, die größer als die Kontaktfläche (7) der Kontaktstruktur (6) ist, aufweist, und
eine Grenzfläche des Schichtstapels (5), die der Strahlungsaustrittsfläche (4) gegenüberliegt, im Bereich der Aussparung derart verändert ist, dass sich ein Kontaktwiderstand zwischen dem Schichtstapel (5) und dem ausgesparten Bereich der ersten Spiegelschicht (2) erhöht, wobei die Grenzfläche im Bereich der Aussparung nicht elektrisch leitend ist, und die Aussparung der ersten Spiegelschicht (2) eine zweite Spiegelschicht (8) aufweist.

2. Lichtemittierende Dünnfilm-Diode gemäß Anspruch 1, wobei
die laterale Ausdehnung der Aussparung um 5 µm bis 20 µm größer als die laterale Ausdehnung der Kontaktfläche (7) der Kontaktstruktur (6) ist.

3. Lichtemittierende Dünnfilm-Diode gemäß einem der vorhergehenden Ansprüche, wobei
eine dem Schichtstapel (5) zugewandte Hauptfläche der Kontaktstruktur (6) eine reflektierende Schicht (9) aufweist.

4. Lichtemittierende Dünnfilm-Diode gemäß einem der vorhergehenden Ansprüche, wobei
die Strahlungsaustrittsfläche (4) des Schichtstapels (5) aufgeraut ist.

5. Lichtemittierende Dünnfilm-Diode gemäß einem der vorhergehenden Ansprüche, wobei
die Bereiche des Schichtstapels (5), auf denen die Kontaktstruktur (6) angeordnet ist, eine geringere Schichthöhe aufweisen als Bereiche des Schichtstapels (5), auf denen keine Kontaktstruktur (6) angeordnet ist.

6. Lichtemittierende Dünnfilm-Diode gemäß einem der vorhergehenden Ansprüche, wobei
mindestens eine der Seitenflächen des Schichtstapels (5) eine weitere reflektierende Schicht (12) aufweist.

7. Lichtemittierende Dünnfilm-Diode gemäß einem der vorhergehenden Ansprüche, wobei
auf der Strahlungsaustrittsfläche (4) der lichtemittierenden Dünnfilm-Diode eine Lumineszenzkonversionsschicht (11) aufgebracht ist.

8. Lichtemittierende Dünnfilm-Diode gemäß einem der vorhergehenden Ansprüche, wobei die erste Spiegelschicht (2) Ag enthält und die Barriereschicht (3) dazu ausgebildet ist, eine Ag-Migration aus der ersten Spiegelschicht (2) zu verhindern.

9. Lichtemittierende Dünnfilm-Diode gemäß einem der vorhergehenden Ansprüche, wobei die Barriereschicht (3) TiWN enthält.

10. Verfahren zur Herstellung einer lichtemittierenden Dünnfilm-Diode gemäß einem der vorhergehenden Ansprüche, mit den Verfahrensschritten:
- Bereitstellen eines Aufwachssubstrats,
- epitaktisches Aufwachsen eines Schichtstapels (5), der geeignet ist, elektromagnetische Strahlung zu erzeugen,
- Aufbringen einer ersten Spiegelschicht (2), die eine Aussparung in einem Bereich, der einem vorgesehenen Bereich einer Kontaktstruktur (6) gegenüber liegt, aufweist und die als reflektierende Kontaktschicht ausgeführt ist,
- Aufbringen einer Barriereschicht (3) auf der ersten Spiegelschicht (2),
- Ablösen des Schichtstapels (5) von dem Aufwachssubstrat,
- Aufbringen einer Kontaktstruktur (6), die eine Kontaktfläche (7) aufweist, auf der der ersten Spiegelschicht (2) gegenüberliegenden Seite des Schichtstapels (5), wobei die Kontaktstruktur (6) in einem der Aussparung der ersten Spiegelschicht (2) gegenüberliegenden Bereich aufgebracht wird, und die Kontaktfläche (7) der Kontaktstruktur (6) kleiner als die Aussparung der ersten Spiegelschicht (2) ist.

11. Verfahren gemäß Anspruch 10, wobei
die Grenzfläche des Schichtstapels (5) vor Aufbringen der Barriereschicht (3) in dem Bereich der Aussparung der ersten Spiegelschicht durch einen Plasmaprozess oder Sputterprozess beschädigt wird.

12. Verfahren gemäß Anspruch 11, wobei
eine zweite Spiegelschicht (8) vor Aufbringen der Barriereschicht (3) in die Aussparung der ersten Spiegelschicht (2) eingebracht wird.

13. Verfahren gemäß einem der Ansprüche 10 bis 12, wobei
die der ersten Spiegelschicht (2) gegenüberliegenden Grenzfläche des Schichtstapels (5) vor Aufbringen der Kontaktstruktur (6) aufgeraut wird.

14. Verfahren gemäß einem der Ansprüche 10 bis 13, wobei
vor Aufbringen der Kontaktstruktur (6) auf den Schichtstapel (5) eine reflektierende Schicht (9) auf die Teilbereiche des Schichtstapels (5) aufgebracht wird, die für die Kontaktstruktur (6) vorgesehen sind.

## Claims

1. Light-emitting thin-film diode, comprising
- a barrier layer (3),
- a first mirror layer (2) succeeding the barrier layer (3), which first mirror layer is embodied as a reflective contact layer,
- a layer stack (5) succeeding the first mirror layer (2) and having at least one active layer (5a) which emits electromagnetic radiation, and
- at least one contact structure (6) which succeeds the layer stack (5), is arranged on a radiation exit area (4) and has a contact area (7), wherein the barrier layer (3) is designed to prevent diffusion of material into the first mirror layer (2), **characterized in that** the first mirror layer (2) has, in a region lying opposite the contact area (7) of the contact structure (6), a cutout which is larger than the contact area (7) of the contact structure (6), and an interface of the layer stack (5) which lies opposite the radiation exit area (4) is altered in the region of the cutout in such a way that a contact resistance between the layer stack (5) and the cut-out region of the first mirror layer (2) is increased, wherein the interface is not electrically conductive in the region of the cutout, and
the cutout of the first mirror layer (2) has a second mirror layer (8).

2. Light-emitting thin-film diode according to Claim 1, wherein
the lateral extent of the cutout is 5 µm to 20 µm larger than the lateral extent of the contact area (7) of the contact structure (6).

3. Light-emitting thin-film diode according to either of the preceding claims, wherein
a main area of the contact structure (6) which faces the layer stack (5) has a reflective layer (9).

4. Light-emitting thin-film diode according to any of the preceding claims, wherein
the radiation exit area (4) of the layer stack (5) is roughened.

5. Light-emitting thin-film diode according to any of the preceding claims, wherein
the regions of the layer stack (5) on which the contact structure (6) is arranged have a smaller layer height than regions of the layer stack (5) on which no contact structure (6) is arranged.

6. Light-emitting thin-film diode according to any of the preceding claims, wherein
at least one of the side areas of the layer stack (5) has a further reflective layer (12).

7. Light-emitting thin-film diode according to any of the preceding claims, wherein
a luminescence conversion layer (11) is applied on the radiation exit area (4) of the light-emitting thin-film diode.

8. Light-emitting thin-film diode according to any of the preceding claims, wherein
the first mirror layer (2) contains Ag and the barrier layer (3) is designed to prevent Ag migration from the first mirror layer (2).

9. Light-emitting thin-film diode according to any of the preceding claims, wherein
the barrier layer (3) contains TiWN.

10. Method for producing a light-emitting thin-film diode according to any of the preceding claims, comprising the following method steps:
- providing a growth substrate,
- epitaxially growing a layer stack (5) suitable for generating electromagnetic radiation,
- applying a first mirror layer (2), which has a cutout in a region lying opposite an intended region of a contact structure (6) and which is embodied as a reflective contact layer,
- applying a barrier layer (3) on the first mirror layer (2),
- stripping the layer stack (5) from the growth substrate,
- applying a contact structure (6), which has a contact area (7), on the opposite side of the layer stack (5) with respect to the first mirror layer (2), wherein the contact structure (6) is applied in a region lying opposite the cutout of the first mirror layer (2), and the contact area (7) of the contact structure (6) is smaller than the cutout of the first mirror layer (2).

11. Method according to Claim 10, wherein
the interface of the layer stack (5) is damaged before the application of the barrier layer (3) in the region of the cutout of the first mirror layer by means of a plasma process or sputtering process.

12. Method according to Claim 11, wherein
a second mirror layer (8) is introduced into the cutout of the first mirror layer (2) before the application of the barrier layer (3).

13. Method according to any of Claims 10 to 12, wherein
the interface of the layer stack (5) which lies opposite the first mirror layer (2) is roughened before the application of the contact structure (6).

14. Method according to any of Claims 10 to 13, wherein before the contact structure (6) is applied to the layer stack (5), a reflective layer (9) is applied to the partial regions of the layer stack (5) which are intended for the contact structure (6).

## Revendications

1. Diode électroluminescente à couches minces, comprenant :
- une couche formant barrière (3) ;
- une première couche formant miroir (2) mise en place en aval de la couche formant barrière (3), laquelle couche formant miroir est conçue sous la forme d'une couche de contact réfléchissante ;
- un empilement de couches (5) mis en place en aval de la première couche formant miroir (2), lequel empilement de couches (5) présente au moins une couche active (5a) qui émet un rayonnement électromagnétique ; et
- au moins une structure de contact (6) mise en place en aval de l'empilement de couches (5), laquelle structure de contact est disposée sur une surface de sortie de rayonnement (4) et présente une surface de contact (7), où la couche formant barrière (3) est conçue en ce sens qu'elle est destinée à empêcher une diffusion de matériau dans la première couche formant miroir (2),
**caractérisée en ce que**
la première couche formant miroir (2) présente un évidement dans une zone se trouvant à l'opposé de la surface de contact (7) de la structure de contact (6), lequel évidement est plus grand que la surface de contact (7) de la structure de contact (6) ; et **caractérisée en ce que**
une interface de l'empilement de couches (5), laquelle se situe à l'opposé de la surface de sortie de rayonnement (4), est altérée de telle sorte dans la zone de l'évidement qu'une résistance de contact entre l'empilement de couches (5) et la zone évidée de la première couche formant miroir (2) s'en trouve augmentée, où l'interface n'est pas électriquement conductrice dans la zone de l'évidement et où l'évidement de la première couche formant miroir (2) présente une deuxième couche formant miroir (8).

2. Diode électroluminescente à couches minces selon la revendication 1, où la dilatation latérale de l'évidement est supérieure d'une valeur comprise entre 5 µm et 20 µm par rapport à la dilatation latérale de la surface de contact (7) de la structure de contact (6).

3. Diode électroluminescente à couches minces selon l'une des revendications précédentes, où une surface principale, laquelle fait face à l'empilement de couches (5) de la structure de contact (6), présente une couche (9) réfléchissante.

4. Diode électroluminescente à couches minces selon l'une des revendications précédentes, où la surface de sortie de rayonnement (4) de l'empilement de couches (5) est rendue rugueuse.

5. Diode électroluminescente à couches minces selon l'une des revendications précédentes, où les zones de l'empilement de couches (5), sur lesquelles est disposée la structure de contact (6), présentent une hauteur de couche inférieure par rapport aux zones de l'empilement de couches (5), sur lesquelles aucune structure de contact (6) n'est disposée.

6. Diode électroluminescente à couches minces selon l'une des revendications précédentes, où au moins l'une des surfaces latérales de l'empilement de couches (5) présente une autre couche (12) réfléchissante.

7. Diode électroluminescente à couches minces selon l'une des revendications précédentes, où une couche de conversion de la luminescence (11) est appliquée sur la surface de sortie de rayonnement (4) de la diode électroluminescente à couches minces.

8. Diode électroluminescente à couches minces selon l'une des revendications précédentes, où la première couche formant miroir (2) contient de l'argent et la couche formant barrière (3) est conçue en ce sens qu'elle est destinée à empêcher une migration de l'argent depuis la première couche formant miroir (2).

9. Diode électroluminescente à couches minces selon l'une des revendications précédentes, où la couche formant barrière (3) contient du TiWN.

10. Procédé destiné à la fabrication d'une diode électroluminescente à couches minces selon l'une des revendications précédentes et comportant les phases de procédé suivantes :
- mise à disposition d'un substrat de croissance ;
- croissance épitaxiale d'un empilement de couches (5), lequel est adapté à la génération d'un rayonnement électromagnétique ;
- application d'une première couche formant miroir (2) qui présente un évidement dans une zone, laquelle se trouve à l'opposé d'une zone prévue d'une structure de contact (6), et où ladite première couche formant miroir est conçue sous la forme d'une couche de contact réfléchissante ;
- application d'une couche formant barrière (3) sur la première couche formant miroir (2) ;
- retrait de l'empilement de couches (5) hors du substrat de croissance ;
- application d'une structure de contact (6) qui présente une surface de contact (7), sur la face de l'empilement de couches (5) qui se trouve à l'opposé de la première couche formant miroir (2), où la structure de contact (6) est appliquée dans une zone se trouvant à l'opposé de l'évidement de la première couche formant miroir (2) et où la surface de contact (7) de la structure de contact (6) est plus petite que l'évidement de la première couche formant miroir (2).

11. Procédé selon la revendication 10, selon .lequel l'interface de l'empilement de couches (5) est endommagée par un procédé plasma ou par un processus de pulvérisation cathodique (sputtering) avant l'application de la couche formant barrière (3) dans la zone de l'évidement de la première couche formant miroir.

12. Procédé selon la revendication 11, selon lequel une deuxième couche formant miroir (8) est mise en oeuvre avant l'application de la couche formant barrière (3) dans l'évidement de la première couche formant miroir (2).

13. Procédé selon l'une des revendications 10 à 12, selon lequel l'interface de l'empilement de couches (5) se trouvant à l'opposé de la première couche formant miroir (2) est rendue rugueuse avant l'application de la structure de contact (6).

14. Procédé selon l'une des revendications 10 à 13, selon lequel une couche (9) réfléchissante est appliquée sur les zones partielles de l'empilement de couches (5) avant l'application de la structure de contact (6) sur l'empilement de couches (5), lesquelles zones partielles sont prévues pour la structure de contact (6).
